(19) **Europäisches Patentamt**

**European Patent Office**

**Office européen des brevets**

(11) **EP 0 717 503 B1**

(12) **EUROPÄISCHE PATENTSCHRIFT**

(45) Veröffentlichungstag und Bekanntmachung des Hinweises auf die Patenterteilung:
**18.07.2001 Patentblatt 2001/29**

(51) Int Cl.$^7$: **H03M 7/40**, H04J 3/16

(21) Anmeldenummer: **96102114.4**

(22) Anmeldetag: **12.04.1990**

(54) **Digitales Codier- und Decodierverfahren**

Digital coding and decoding method

Procédé de codage et de décodage numérique

(84) Benannte Vertragsstaaten:
**AT BE CH DE DK ES FR GB GR IT LI LU NL SE**

(30) Priorität: **17.04.1989 DE 3912605**

(43) Veröffentlichungstag der Anmeldung:
**19.06.1996 Patentblatt 1996/25**

(62) Dokumentnummer(n) der früheren Anmeldung(en) nach Art. 76 EPÜ:
**94106503.9 / 0 612 156**
**90107082.1 / 0 393 526**

(73) Patentinhaber: **FRAUNHOFER-GESELLSCHAFT ZUR FÖRDERUNG DER ANGEWANDTEN FORSCHUNG E.V.**
**80636 München (DE)**

(72) Erfinder:
• **Grill, Bernhard**
  **D-91207 Lauf (DE)**
• **Sporer, Thomas**
  **D-90766 Fürth (DE)**
• **Kürten, Bernd**
  **D-90587 Obermichelbach (DE)**
• **Seitzer, Dieter**
  **D-91054 Erlangen (DE)**
• **Eberlein, Ernst**
  **D-91091 Grossenseebach (DE)**
• **Brandenburg, Karl-Heinz**
  **D-91056 Erlangen (DE)**

(74) Vertreter: **Münich, Wilhelm, Dr. et al**
**Dr. Münich & Kollegen**
**Anwaltskanzlei**
**Wilhelm-Mayr-Strasse 11**
**80689 München (DE)**

(56) Entgegenhaltungen:
**EP-A- 0 492 537**   **WO-A-88/01811**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung bezieht sich auf ein digitales Codierverfahren für die Übertragung und/oder Speicherung von akkustischen Signalen und insbesondere von Musiksignalen gemäß dem Oberbegriff des Patentanspruchs 1. Ferner wird ein dem Codierverfahren nachgeschaltetes Decodierverfahren beschrieben.

Verfahren gemäß dem Oberbegriff des Patentanspruchs 1 sind beispielsweise aus der DE-PS 33 10 480 oder aus der WO 88/ 01811 bekannt.

Insbesondere bezieht sich die Erfindung auf das in der WO 88/01811 erstmals vorgeschlagene digitale Codierverfahren für die Übertragung und/oder Speicherung von akustischen Signalen, das als OCF(=Optimum Coding in the Frequency Domain)-Verfahren bezeichnet wird.

Bei digitalen Codierverfahren für die Übertragung und/oder Speicherung von akustischen Signalen und insbesondere von Musiksignalen wird im allgemeinen so vorgegangen, daß zunächst die Abtastwerte des akustischen Signals in eine Folge von zweiten Abtastwerten transformiert werden, die die spektrale Zusammensetzung des akustischen Signals wiedergeben. Diese Folge von zweiten Abtastwerten wird dann entsprechend den Anforderungen mit unterschiedlicher Genauigkeit quantisiert und teilweise oder ganz mittels eines Codierers codiert. Bei der Wiedergabe erfolgt eine entsprechende Decodierung und Rücktransformation.

Die Umsetzung der Abtastwerte des akustischen Signals in eine Folge zweiter Abtastwerte kann dabei mittels einer Transformation oder einer Filterbank erfolgen, wobei gegebenenfalls das Ausgangssignal der Filterbank "unter"abgetastet wird, so daß eine Blockbildung wie bei einer Transformation entsteht.

Bei Codierungen, bei denen der Beginn eines Codewortes nur durch das Ende des vorhergehenden Codewortes bestimmt

ist, wie dies beispielsweise beim Huffmancode der Fall ist, führt ein Übertragungsfehler zu einer Fehlerfortpflanzung.

Der Erfindung liegt die Aufgabe zugrunde, digitale Codierverfahren und insbesondere das aus der WO 88/01811 bekannte Verfahren derart weiterzubilden, daß bereits bei Datenraten von cirka 2 bit/ATW eine Codierung von Musik mit einer der Compact-Disc vergleichbaren Qualität und bei Datenraten von 1,5 bit/ATW die Codierung von Musik mit einer Qualität von guten UKW-Rundfunksendungen möglich ist. Überdies sollen insbesondere die vorstehend genannten Übertragungsfehler vermieden werden. Ein für die Decodierung zuständiges Verfahren soll die Signale unter Beibehaltung aller Vorteile des Codierverfahrens rücktransformieren.

Eine erfindungsgemäße Lösung dieser Aufgabe ist mit ihren Weiterbildungen und Ausgestaltungen in den Patentansprüchen angegeben.

Die Erfindung wird nachstehend anhand der Zeichnung näher beschrieben, in der zeigen:

Fig. 1     Codewörter in einem festen Raster,
Fig. 2     die Anordnung wichtiger Nachrichtenteile in einem festen Raster,
Fig. 3     schematisch den als "Bitsparkasse" dienenden Ringpuffer, und
Fig. 4     die Häufigkeitsverteilung des Spektrums.

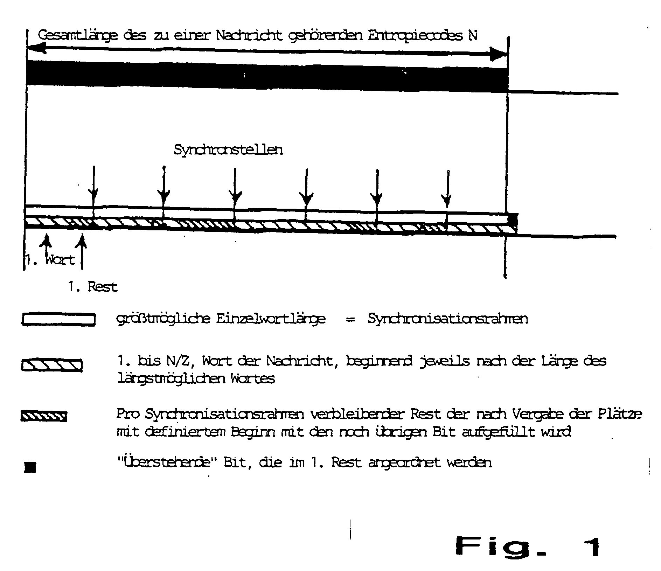

Zur Vemeidung von Übertragungsfehlern ordnet man erfindungsgemäß zunächst einen Teil der Codewörter in einem Raster an, dessen Länge beispielsweise größer oder gleich der des längsten Codewortes ist, so kommt es für diesen Teil der Codewörter zu keiner Fehlerfortpflanzung mehr, da ihr Beginn nicht mehr durch das Ende des vorhergehenden Codewortes bestimmt ist. Die restlichen Codewörter werden in die verbleibenden Lücken verteilt. Ein Beispiel hierfür zeigt Figur 1. Wird die verwendete Codetabelle derart aufgebaut, daß man aus den ersten Stellen der Codewörter bereits auf den Bereich der Codetabelle schließen kann, so kann die Länge des verwendeten Rasters auch kleiner als die Länge des längsten Codewortes sein. Die nicht mehr ins Raster passenden Stellen werden wie die restlichen Codewörter in die verbleibenden Lücken verteilt. Durch die Verwendung dieser kürzeren Rasterlänge lassen sich mehr Codewörter in diesem Raster anordnen und die Feherfortpflanzung beschränkt sich auf die letzten Stellen dieser Codewörter, die durch die oben beschriebene Struktur der Codetabelle nur nur von untergeordneter Bedeutung sind. Diese Umsortierung führt zu keiner Verminderung der Codeeffizienz.

Dies soll im folgenden anhand des Beispiels erläutert werden:

| Wert | Codewort |
|------|----------|
| 0    | 0        |
| 1    | 100      |
| 2    | 101      |
| 3    | 110      |

(fortgesetzt)

| Wert | Codewort |
|---|---|
| 4 | 111 |

Bereits die ersten beiden Stellen entscheiden, ob der Wert aus dem Bereich "0", "1-2" oder "3-4" ist. Daher wird eine Rasterlänge von 2 gewählt. Es soll folgende Wertefolge codiert übertragen werden:

| | | | | | | |
|---|---|---|---|---|---|---|
| Wertefolge | 2 | 0 | 4 | | 0 | |
| Codewörter | 101 | 0 | 111 | | 0 | |
| ohne Codesortierung ergibt ein Bitfehler im ersten Bit die Bitfolge | | | | | | |
| | 001 | 0 | | 111 | | 0 |
| zerlegt also | 0 | 0 | | 101 | | 110 |
| decodiert | 0 | 0 | | 2 | | 3 |
| mit Codesortierung (Rasterlänge 2) ergibt sich folgende Bitfolge | | | | | | |
| zunächst | 10 | 0 | | 11 | | 0 |
| Rest | 1 | | | 1 | | |
| Rest in Lücken | 10 | 0 1 | | 11 | | 0 1 |
| mit einem Bitfehler im ersten Bit ergibt sich die Bitfolge | | | | | | |
| | 00 | 01 | | 11 | | 01 |
| Bereich | 0 | 0 | | 3-4 | | 0 |
| d.h. nur für das gestörte Codewort konnte der Bereich nicht mehr richtig dekodiert werden. | | | | | | |

Weiterhin ist es gemäß Anspruch 2 möglich, wichtige Nachrichtenteile in einem festen Raster anzuordnen:

Die Übertragungssicherheit kontinuierlich aufeinander folgender Nachrichten unterschiedlicher Länge mit Nachrichtenteilen unterschiedlicher Wichtigkeit läßt sich folgendermaßen verbessern: Die mittlere Nachrichtenlänge des kontinuierlichen Bitstromes stellt den Abstand der Punkte eines äquidistanten Rasters dar. Die wichtigten Nachrichtenteile werden nun in diesem festen Raster angeordnet. Zusätzlich wird in diesem wichtigen Informationsteil die Position des zugehörigen weniger wichtigen Teils mit übertragen. Durch den äquidistanten Abstand der wichtigten Information ist im Falle eines Übertragungsfehlers die Neusynchronisation leichter zu erreichen.

Im folgenden soll die Fehlerbegrenzung bei Entropiecodes gemäß Anspruch 3 erläutert werden:

Im Falle eines Bitfehlers im Entropiecode gehen im Fehlerfall in der Regel alle der Fehlerstelle folgenden Informationen verloren. Durch Markierung des Blockanfangs mit einem bestimmten Bitmuster und der zusätzlichen Übertragung der Entropiecodelänge läßt sich der entstehende Fehler auf den Nachrichtenblock, der den Bitfehler enthält, begrenzen. Dies geschieht folgendermaßen:

Nach erfolgreicher Decodierung einer Nachricht müßte der Beginn des nächsten Nachrichtenblocks und damit eine Blockanfangsmarkierung folgen. Ist dies nicht der Fall, wird mit Hilfe der Entropiecodelänge überprüft, ob die Decodierung sich an der nach der Entropiecodelänge zu erwartenden Stelle befindet. Ist dies der Fall, wird ein Fehler in der Blockanfangsmarkierung angenommen und korrigiert. Ist dies nicht der Fall, wird geprüft, ob an der durch die Entropiecodelänge angegebene Bitstromposition eine Blockanfangsmarkierung folgt, die dann mit großer Wahrscheinlichkeit den Beginn des nächsten Blocks markiert. Wird keine Blockanfangsmarkierung getroffen liegen mindestens 2 Fehler (Decodierung/Blockanfangsmarkierung oder Entropiecodelänge/Decodierung oder Blockanfangsmarkierung/ Entropiecodelänge) vor und es muß neu synchronisiert werden.

Weiterhin ist es möglich, einen Synchronisationsschutz bzw. eine Synchronisationserkennung vorzusehen:

Bei kontinuierlichen Datenströmen, die aus Blöcken unterschiedlicher Länge zusammengesetzt sind, ergibt sich das Problem, daß Synchronwörter zur Kennzeichnung der Blockanfänge sich auch zufällig im Datenstrom befinden können. Die Wahl sehr langer Synchronwörter verringert zwar diese Wahrscheinlichkeit, kann sie aber zum einen nicht zu null setzen und führt zum anderen zu einer Verminderung der Übertragungskapazität. Ein Paar von Schaltungen, das einem gefundenen Synchronwort am Blockanfang eine "1" und innerhalb eines Blockes eine "0" anhängt (bzw. umgekehrt am Blockanfang eine "0" und sonst eine "1"), ist aus der Literatur bekannt (z.B.: intel "BITBUS"-frameformat). Die Anwendung zur Übertragung von codierten Musiksignalen ist erfindungsgemäß. Angepaßt an diese Anwendung enthält die "Synchronisationserkennung" die Möglichkeit, in Bereichen, in denen ein Synchronwort erwartet wird, dieses als solches zu akzeptieren, auch wenn es durch Übertragungsfehler in einigen Stellen verändert wurde.

Im Anspruch 13 ist die Beschränkung der Maximalzahl der Iterationen angegeben: Ziel ist die Begrenzung der zur Quantisierererkennzeichnung zu übertragenden Bits. Ausgehend von einem Quantisiererstartwert ist nur eine begrenzte Abweichung von diesem Startwert zugelassen, die mit n Bit dargestellt werden kann. Zur Einhaltung dieser Bedingung wird vor jedem Durchgang durch die äußere Schleife geprüft, ob noch gewährleistet ist, daß ein weiter Aufruf der inneren Schleife mit einem gültigen Ergebnis beendet werden kann.

Auch dies soll im folgenden anhand eines Beispiels erläutert werden:

Ausgehend vom Quantisiererstartwert wird der Quantisierer in Stufen von $q = ^4\sqrt{2}$ verändert. Im ungünstigsten Fall werden in der äußeren Schleife alle Frequenzgruppen verstärkt um den Faktor 2. Sind noch 4 Vergröberungen des Quantisierers um $q = ^4\sqrt{2}$ möglich, ist gewährleistet, daß die innere Schleife mit einem in den erlaubten Bitrahmen passenden Ergebnis beendet wird. Zur Übertragung sind für die Abweichung vom Startwert 5 Bit vorgesehen, so daß als Abweichung vom Startwert maximal 31 möglich ist. Die innere Schleife wird also nicht mehr aufgerufen, falls bereits 28 oder mehr erreicht ist, da in diesem Fall nicht mehr sichergestellt ist, daß mit der erlaubten Bitzahl der Block codiert werden kann.

In den Ansprüchen 4 und 5 sind vorteilhafte Ausgestaltungen angegeben, die die Psychoakustik dadurch verbessern, daß psychoakustische Maßnahmen über mehrere Blöcke angewendet werden:

Das verwendete Verfahren soll anhand eines Beispiels beschrieben werden. Um das Beispiel einfach zu halten, sei die Zahl der Frequenzgruppen zu 2 angenommen. Die Werte für die jeweils erlaubte Störung etc. sind ebenfalls Beispielswerte, die in der praktischen Ausführung des Codierverfahrens anders gewählt werden:

Es sei die erlaubte Störung = 0,1 * Signalleistung je Frequenzgruppe. Die Leistungswerte sind ohne Maßangabe angegeben. Der Maßstab kann willkürlich gewählt werden, da nur Verhältnisangaben und nicht der Absolutbetrag der Leistungswerte Verwendung finden.

|  | Frequenzgruppe | Leistung | erlaubte Störung |
|---|---|---|---|
| erster Block | FG 1: | 50. | 5. |
|  | FG 2: | 60. | 6. |
| zweiter Block | FG 1: | 1000. | 100. |
|  | FG 2: | 100. | 10. |

Der "Vergessensfaktor", mit dem berücksichtigt wird, daß die Signalleistung des jeweils vorhergehenden Blocks weniger in die Berechnung der aktuell erlaubten Störung eingeht als die Signalleistung des aktuellen Blocks, sei zu 2 gewählt. Die erlaubte Störung im zweiten Block wird dann berechnet als Minimum der aus den Daten des zweiten Blocks errechneten erlaubten Störung und der aus den Daten des ersten Blocks errechneten, korrigiert um den Vergessens-faktor. Es ergibt sich im Beispiel für den zweiten Block für die Frequenzgruppe FG 1: min(2*6,100)=12 und für FG 2:min (2*5, 10)=10 als erlaubte Störung.

Anspruch 8 ff. kennzeichnet eine erfindungsgemäße "Bitsparkasse": Im einfachsten Fall wird, wie schon in der WO 88/01811 beschrieben, für jeden Block eine bestimmte Datenrate (Bitzahl) zur Verfügung gestellt. Sofern nicht die gesamte Datenrate zur Codierung des Blockes Verwendung findet, werden die "übriggebliebenen" Bits der für den nächsten Block zur Verfügung stehenden Bitzahl dazugefügt. Erfindungsgemäß wird zwar im Mittel eine konstante Datenrate eingehalten, aber die einem Block zur Verfügung gestellte oder von dem Block beanspruchte Bitanzahl kann abhängig von den Signaleigenschaften, der Kapazität des Übertragungskanals oder zur Vereinfachung der Codierung von der durchschnittlichen Datenrate abweichen.

In der vorteilhaften Erweiterung dieses Verfahrens werden gemäß Anspruch 10 eine maximale untere und obere Summenabweichung der Datenrate zugelassen. Die Summenabweichung der Datenrate (Abweichung der Bitzahlsummen der Datenblöcke von der aus der gewünschten konstanten Datenrate errechenbaren Bitzahlsumme) wird "Bitsparkasse" genannt.

Die Bitsparkasse wird gefüllt durch die im Normalbetrieb jeweils nicht vollständige Nutzung der aktuell zur Verfügung stehenden Bitzahl. Solange nicht eine obere Grenze der Bitsparkasse (=untere Grenze der Abweichung der Summenbitzahl) erreicht ist, werden jedem Block von neuem nur die aus der mittleren Datenrate errechenbare Bitzahl zur Verfügung gestellt, nicht jedoch die im jeweils vorhergehenden Block "übriggebliebenen" Bits.

Wenn z.B. bei starken Pegelanstiegen des Signals (z.B. Triangel) für einen Datenblock aufgrund der Berücksichtigung der erlaubten Störung des letzten Datenblocks (siehe oben) eine deutlich geringere erlaubte Störung errechnet wird, als dies ohne die Berücksichtigung der Daten des letzten Blocks der Fall wäre, dann werden der inneren Iterationsschleife des aktuellen Blocks mehr Bits zur Codierung zur Verfügung gestellt und der Wert der Summenabweichung ("Bitsparkasse") entsprechend korrigiert. Die Zahl der zusätzlichen Bits wird so gewählt, daß die maximale Summenabweichung ("Mindeststand der Bitsparkasse") nicht überschritten werden kann. Im obigen Beispiel könnte die Zahl der zusätzlichen Bits z.B. wie folgt berechnet werden:

In der ersten Frequenzgruppe des zweiten Blocks wäre die erlaubte Störung = 100., wenn die Daten des ersten Blocks nicht berücksichtig würden. Das Verhältnis zwischen erlaubter Störung mit und ohne Berücksichtigung der Daten des letzten Blockes ist also 100/12 = 8.33, das sind ca. 10*log (8.33) = 9.2dB.

Wenn angenommen wird, daß das Quantisierungsrauschen bei Quantisierung mit einem zusätzlichen Bit pro Wert um ca. 6dB gesenkt wird, dann sind pro Spektralwert der Frequenzgruppe ca. 1,5 bit notwendig, um die geringere erlaubte Störung zu erreichen. Die Zahl der aus der Bitsparkasse zu verwendeten Bits beträgt also im Beispiel 1,5* Zahl der Spektralwerte der Frequenzgruppe.

Anspruch 9 kennzeichnet die Synchronisation von Ausgangs- und Eingangsbittakt:

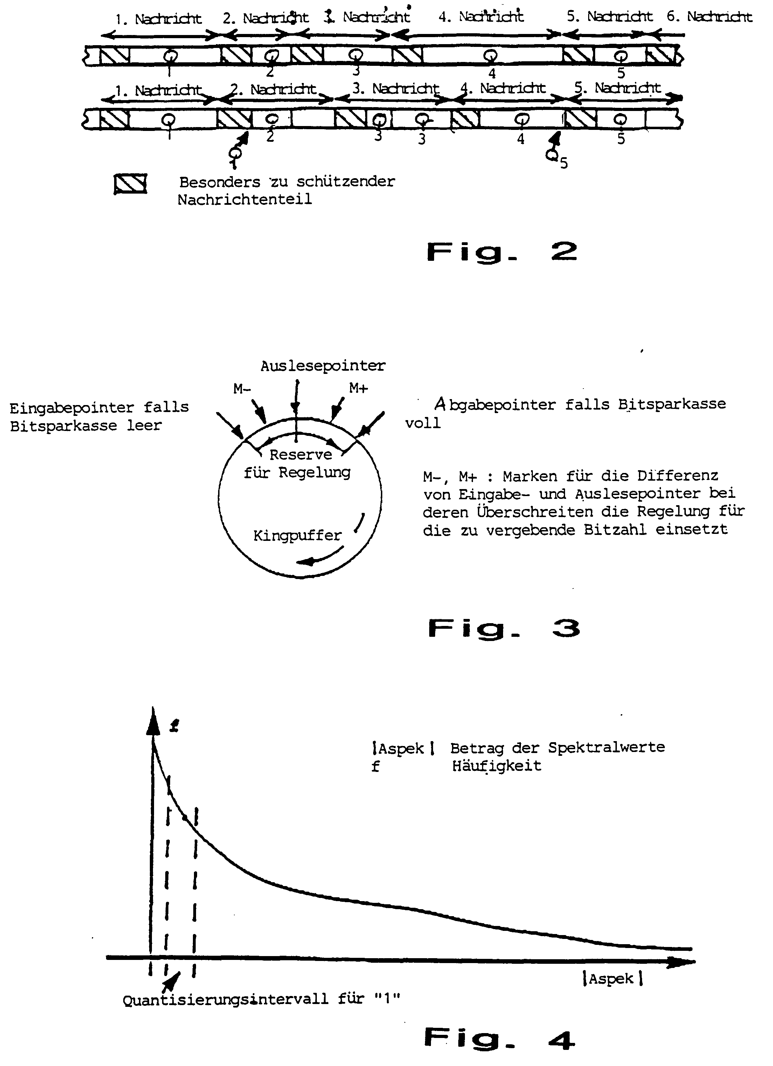

Bei Codiersystemen mit beliebigem Verhältnis von Eingangszu Ausgangsbittakt besteht das Problem, daß die zu vergebende Bitzahl ein unendlicher Bruch sein kann. Damit ist die Synchronisation durch eine Langzeitmittelung der zu vergebenden Bitzahl, die bei einem endlichen Bruch möglich wäre, ausgeschlossen. Ein Auseinanderlaufen von Eingang und Ausgang wird durch eine Regelung verhindert, die den Abstand von Ein- und Ausgabezeiger eines Pufferspreichers beobachtet. Wird der Abstand geringer, wird die Bitzahl verringert und umgekehrt. Bei einem konstanten Verhältnis von Eingangs- zu Ausgangsbittakt bzw. bei einem um einen konstanten Mittelwert variirenden Verhältnis von Eingangszu Ausgangsbittakt ist es ausreichend die zu vergebende Bitzahl um jeweils 1 Bit zu variieren. Die maximale Abweichung vom Mittelwert bestimmt jedoch die vorzusehende minimale Puffergröße. Dies soll anhand von Fig. 3 an einer konkreten OCF-Implementierung erläutert werden:

Eingangsdaten sind Abtastwerte, die mit konstanter Frequenz angeliefert werden. Der Ausgang ist an einen Kanal mit konstanter Bitrate angeschlossen. Damit ist ein konstantes mittleres Verhältnis von Eingangs- zu Ausgangsbittakt vorgegeben. Im Coder kann die pro Block an den Ausgang weitergegebene Bitzahl, bedingt durch die Bitsparkasse, schwanken. D.h. es gibt Blöcke für die mehr oder weniger als die durchschnittliche pro Block verfügbare Bitzahl (== Eingangsbittakt/Ausgangsbittakt*Blocklänge), die eine nichtnatürliche Zahl sein kann, an den Ausgang weitergegeben wird. Diese Schwankung wird durch ein FIFO (Ringpuffer) am Ausgang ausgeglichen. Die FIFO-Länge ist entsprechend dem maximalen Inhalt der Bitsparkasse gewählt. Ist die durchschnittliche pro Block verfügbare Bitzahl eine nichtnatürliche Zahl, muß entweder die nächst größere bzw. die nächst kleinere natürliche Bitzahl pro Block vergeben werden. Wird die nächst größere bzw. nächst kleinere gewählt, werden die FIFO-Eingangs- und Ausgangszeiger aufeinanderzulaufen bzw. auseinanderlaufen. Um den Sollabstand werden nun in beide Richtungen Sollabstände definiert, bei deren Überschreiten von nächst größeren zum nächst kleineren (oder umgekehrt) umgeschaltet wird. Dabei wird als Startwert für die zu vergebende Bitzahl eine dieser beiden Näherungen vorgegeben. Bei ausreichender Puffergröße läßt sich diese Regelung auch dazu benützen, diesen Startwert zu ermitteln. Im Zusammenhang mit der Bitsparkasse muß vor dem Pointervergleich der Inhalt der Bitsparkasse berücksichtigt werden.

Wird die Bitzahl um mehr als ein Bit variiert, ist dieses Verfahren auch dann anzuwenden, wenn kein konstanter Mittelwert vorliegt. Aus der Differenz der Pointer wird in diesem Fall die Korrekturbitzahl berechnet.

Die Ansprüche 6 und 7 geben Weiterbildungen an, die u.a. die Nachverdeckung verbessern: Zur Berechnung der erlaubten Störung wird die Signalenergie in den vorhergehende: Datenblöcken einbezogen, indem die erlaubte Störung von einem Datenblock zum nächsten nach Beachtung sämtlicher anderer Parameter zur Bestimmung der aktuellen erlaubten Störung jeweils höchstens um einen bestimmten Faktor abnimmt.

Auch dies soll im folgenden anhand eines Beispiels erläutert werden:

Die erlaubte Störung in der Frequenzgruppe 1 sei im Block 1 gleich 20. Im Block 2 sei die Signalleistung in FG1 gleich 50. Bei einer angenommenen erlaubten Störung von 0,1* Leistung in der Frequenzgruppe wäre die erlaubte Störung gleich 5. Wenn der "Nachverdeckungsfaktor" als -3 dB pro Block angenommen wird, das entspricht einer Halbierung der Leistung, dann wird die erlaubte Störung im Block zu 10(= 0,5 * 20) berechnet.

Ferner ist es möglich, ein Anpassung an verschiedene Bitraten vorzunehmen:

Der Iterationsblock des aus der WO 88/01811 bekannten Verfahrens verteilt die für den Block zur Verfügung stehende Bitzahl entsprechend der Vorgabe der "erlaubten Störung" je Frequenzgruppe. Zur Optimierung des Ergebnisses wird die Berechnung der "erlaubten Störung" der zur Verfügung stehenden Bitzahl angepaßt. Ausgangspunkt ist hierbei die tatsächliche Mithörschwelle, die bei einer "erlaubten Störung" ESO noch nicht verletzt wird. Der für eine bestimmte Bitrate geforderte Störabstand wird so gewählt, daß im Mittel ein gleichmäßiger Verlauf des Störspektrums erreicht wird. Je niedriger die zu vergebende Gesamtbitzahl liegt, umso weniger Störabstand je Gruppe wird gefordert. Dabei wird zwar in einer mit immer niedrigeren Bitraten steigende Anzahl von Blökken die errechnete Mithörschwelle verletzt, doch insgesamt ein gleichmässiger Störverlauf erreicht. Im Gegensatz dazu kann bei höheren Bitraten ein zusätzlicher Sicherheitsabstand zur Mithörschwelle erreicht werden, der z.B. Nachbearbeitung oder Mehrfachcodierung/decodierung des Signals erlaubt.

Als weitere Maßnahme ist eine Bandbreitenbegrenzung durch Löschen bestimmter Frequenzbereiche vor Berechnung der "erlaubten Störung" möglich. Dies kann statisch geschehen oder dynamisch, falls in mehreren Blöcken hintereinander der geforderte Störabstand nur schlecht eingehalten wird.

Bei einem steilem Abfall der Verdeckung zu tiefen Frequenzen hin, d.h. bei der Berechnung der erlaubten Störung ist besonders zu berücksichtigen, daß nur ein geringer Verdekkungseffekt von hohen zu tiefen Frequenzen hin besteht. Die in 1. Näherung berechnete erlaubte Störung wird deshalb, im Falle eines starken Energieanstiegs im Spektrum für die Frequenzgruppen unterhalb des Anstiegs nach unten korrigiert.

Weiterhin wird erfindungsgemäß die Quantisiererkennlinie verbessert: Bei Quantisierung und Rekonstruktion wird die Statistik der unquantisierten Werte beachtet. Diese nimmt in einer gekrümmten Kennlinie streng monoton ab. Dadurch liegt der Erwartungswert jedes Quantisierungsintervalls nicht in der Mitte des Intervalls, sondern näher zu den kleineren Werten verschoben (Fig. 4).

Um den kleinsten Quantisierungsfehler zu erhalten sind zwei Vorgehensweisen möglich:

a) Vorgabe einer Quantisierungskennlinie: Anhand der Quantisierungskennlinie und der statistischen Verteilung der zu quantisierenden Werte wird für jedes Quantisierungsintervall der Erwartungswert bestimmt und als Tabelle für die Rekonstruktion im Decoder verwendet. Der Vorteil dieses Vorgehens liegt in der einfachen Realisierbarkeit und dem geringen Rechenaufwand in Coder und Decoder.

b) Vorgabe der Rekonstruktionskennlinie: Anhand dieser und eines Modells für die Wahrscheinlichkeitsverteilung der Eingangswerte kann eine Quantisiererkennlinie berechnet werden, für die der Erwartungswert jedes Quantisierungsintervalls exakt dem rekonstruiertem Wert dieses Intervalls entspricht. Dies bietet den Vorteil, daß im Decoder keine Tabellen benötigt werden und die Quantisierungskennlinie im Coder an die aktuelle Statistik angepaßt werden kann, ohne daß dies dem Decoder mitgeteilt werden muß.

c) Vorgabe einer Quantisiererkennlinie und Berechnung der Rekonstruktionskennlinie für jeden Wert: Bei gegebener Quantisiererkennlinie und einer Funktion für die Wahrscheinlichkeitsverteilung für die Eingangsdaten kann der Decoder aus diesen jeweils den Rekonstruktionswert berechnen. Dies bietet den Vorteil, daß im Decoder keine Tabellen zur Rekonstruktion benötigt werden. Nachteil dieses Vorgehens ist der höhere Rechenaufwand im Decoder.

Für die Decodierung der übertragenen Signale wird im Anspruch 21 ein Decodierverfahren zur Decodierung der nach dem digitalen Codierverfahren gemäß Anspruch 1 codierten Signale angegeben, bei dem bei der Wiedergabe eine entsprechende Decodierung und Rücktransformation erfolgt.

Hierfür wird insbesondere eine Tabelle verwendet, in der Wertepaare gespeichert sind, von denen der erste Wert des Paares jeweils die Adresse enthält, die im Falle einer "0" im zu dekodierenden Wert anzuspringen ist, und der zweite Wert des Paares die Adresse im Falle einer "1", und daß Tabellenwerte ohne Adreßangabe das Codewort bezeichnen.

Ferner wird ein Raster verwendet, in dem ein Teil der Codewörter variabler Länge angeordnet ist, und daß die restlichen Codewörter in die verbleibenden Lücken verteilt werden, so daß ohne vollständige Decodierung oder bei fehlerhafter Übertragung der Anfang eines Codeworts leichter aufgefunden wird.

Schließlich wird zur Berechnung der rekonstruierten Werte eine Tabelle verwendet, die durch Ermittlung tatsächlicher Erwartungswerte der Eingangswerte eines Quantisierungsintervall erstellt wird.

**Patentansprüche**

**1.** Digitales Codierverfahren für die Übertragung und/oder Speicherung von akustischen Signalen und insbesondere von Musiksignalen, bei dem Abtastwerte des akustischen Signals mittels einer Transformation oder einer Filterbank in eine Folge von zweiten Abtastwerten transformiert werden, die die spektrale Zusammensetzung des akustischen Signals wiedergeben, und diese Folge von zweiten Abtastwerten entsprechend den Anforderungen mit unterschiedlicher Genauigkeit quantisiert und teilweise oder ganz mittels eines Codierers in Codewörter codiert wird, bei dem die Auftrittswahrscheinlichkeit des quantisierten Spektralkoeffizienten mit der Länge des Codes derart korreliert ist, daß das Codewort umso kürzer ist, je häufiger der Spektralkoeffizient auftritt, und bei dem bei der Wiedergabe eine entsprechende Decodierung und Rücktransformation erfolgt,
dadurch **gekennzeichnet,** daß ein Teil der Codewörter variabler Länge in einem Raster angeordnet wird, und daß die restlichen Codewörter in verbleibende Lücken des Rasters verteilt werden, so daß ohne vollständige Decodierung oder bei fehlerhafter Übertragung der Anfang eines Codeworts leichter gefunden werden kann.

**2.** Codierverfahren nach Anspruch 1,
dadurch **gekennzeichnet,** daß zur Verbesserung der Übertragungssicherheit kontinuierlich aufeinanderfolgender Nachrichten mit unterschiedlicher Wichtigkeit ein äquidistantes Raster vorgegeben wird, dessen Rasterlänge der mittleren Länge der zu übertragenden Nachrichten entspricht, und daß die wichtigsten Nachrichtenteile in diesem Raster angeordnet werden, und daß ggflls. zusätzlich zu den wichtigsten Nachrichtenteilen in diesem Raster die Position der weniger wichtigen Nachrichten übertragen wird.

**3.** Codierverfahren nach Anspruch 1 oder 2,
dadurch **gekennzeichnet,** daß zur Ermittlung des Beginns des nächsten Nachrichtenblocks im Falle eines Übertragungsfehlers eine Blockanfangsmarkierung und zusätzlich die Entropiecodelänge übertragen werden.

**4.** Codierverfahren nach einem der Ansprüche 1 bis 3,
dadurch **gekennzeichnet,** daß für die Berechnung einer "erlaubten Störung" eines Datenblockes längere Signalabschnitte verwendet als in einem Block codiert werden, oder die Berechnungsvorschrift von den Ergebnissen vorheriger Zeitabschnitte abhängig ist.

**5.** Codierverfahren nach Anspruch 4,
dadurch **gekennzeichnet**, daß zur Berechnung der "erlaubten Störung" für einen Datenblock eine Analyse der Signalenergie in den verschiedenen Frequenzgruppen durchgeführt wird, und daß jeweils die Werte des vorhergehenden Blocks, die um einen "Vergessens-Faktor" korrigiert sind, sowie die Werte des aktuellen Blocks gemeinsam zur Berechnung der "erlaubten Störung" herangezogen werden.

**6.** Codierverfahren nach Anspruch 4 oder 5,
dadurch **gekennzeichnet**, daß zur Berechnung der "erlaubten Störung" für einen Datenblock die Energiewerte des letzten Datenblocks in der Weise Verwendung finden, daß Werte geringer Amplitude, die auf Werte höherer Amplitude folgen, weniger genau quantisiert werden müssen.

**7.** Codierverfahren nach einem der Ansprüche 4 bis 6,
dadurch **gekennzeichnet**, daß die errechnete erlaubte Störung bei Detektierung eines steilen Energieanstiegs zu hohen Frequenzen hin für die Frequenzgruppe unterhalb des Anstiegs verringert wird.

**8.** Codierverfahren nach einem der Ansprüche 1 bis 7
dadurch **gekennzeichnet,** daß zwar im Mittel eine konstante Datenrate eingehalten wird, daß aber die einem Block zur Verfügung gestellte oder von dem Block beanspruchte Bitanzahl abhängig von den Signaleigenschaften, der Kapazität des Übertragungskanals oder zur Vereinfachung der Codierung von der durchschnittlichen Datenrate abweichen kann.

**9.** Codierverfahren nach Anspruch 8,
dadurch **gekennzeichnet**, daß zur Synchronisation von Codierverfahren mit beliebigem Verhältnis von Eingangs- und Ausgangsbittakt, der "Füllstand" eines mit einem Ausgangsbit-Takt ausgelesenen Puffers als Regelgröße für die zu vergebende Bitzahl dient.

**10.** Codierverfahren nach Anspruch 8 oder 9,
dadurch **gekennzeichnet,** daß die Zahl zur Codierung eines Datenblocks zur Verfügung stehenden Bits in Abhängigkeit von den Signaleigenschaften so geändert wird,
daß einerseits im Mittel eine konstante Datenrate eingehalten wird, und die Summenabweichung von diesem Mittelwert nicht höher als ein bestimmter vorher festgesetzter Wert sowie nicht geringer als ein anderer vorher festgesetzter Wert ist, und
daß andererseits Signalblöcken mit größerem Abstand zwischen Signalleistung in den einzelnen Frequenzgruppen unter jeweiligen "erlaubten Störung" eine größere aktuelle Datenrate "zur Verfügung stehende Bitzahl" zugeteilt wird als Signalblöcken mit einem geringerem Abstand.

**11.** Codierverfahren nach einem der Ansprüche 8 bis 10,
dadurch **gekennzeichnet**, daß von den für einen Block zur Verfügung stehenden Bits die Anzahl der von den Zusatzdaten benötigten Bits, die auf dem selben Kanal übertragen werden, abgezogen werden.

**12.** Codierverfahren nach einem der Ansprüche 8 bis 11,
dadurch **gekennzeichnet,** daß bei Verwendung einer besonderen Bitkombination für ein Synchronwort zur Blocksynchronisation das Synchronwort und alle zufällig mit dem Synchronwort identischen Bitkombinationen mit einem bewußt eingefügten zusätzlichen Bit voneinander unterschieden werden.

**13.** Codierverfahren nach einem der Ansprüche 8 bis 12,
dadurch **gekennzeichnet**, daß die äußere Iterationsschleife abgebrochen wird, falls die innere Schleife innerhalb der maximalen Iterationszahl nicht sicher beendet werden kann.

**14.** Codierverfahren nach einem der Ansprüche 1 bis 13,
dadurch **gekennzeichnet**, daß Bereiche, in denen die "erlaubte Störung" größer als die Signalenergie ist, gelöscht werden.

**15.** Codierverfahren nach einem der Ansprüche 1 bis 14,
dadurch **gekennzeichnet,** daß die entstehende Folge von gelöschten Werten durch ein Bit in der Seiteninformation codiert wird.

**16.** Codierverfahren nach einem der Ansprüche 1 bis 15,
dadurch **gekennzeichnet,** daß die entstehende Folge von gelöschten Werten durch einen Wert in der Tabelle der möglichen Quantisierungsstufenhöhen für jede Frequenzgruppe in der Seiteninformation codiert wird.

**17.** Codierverfahren nach einem der Ansprüche 1 bis 16,
dadurch **gekennzeichnet,** daß die Quantisierung und Rekonstruktion so aneinander angepaßt sind, daß der Quantisierungsfehler im Mittel minimal wird.

**18.** Codierverfahren nach einem der Ansprüche 1 bis 17,
dadurch **gekennzeichnet,** daß die Berechnung der rekonstruierten Werte im Empfänger mittels einer Tabelle geschieht, die durch Ermittlung der tatsächlichen Erwartungswerte der Eingangswerte eines Quantisierungsintervalls erstellt wurde.

**19.** Codierverfahren nach einem der Ansprüche 1 bis 18,
dadurch **gekennzeichnet** daß die Quantisierung über eine Tabelle geschieht, die aus der Rekonstruktionskennlinie und der Wahrscheinlichkeitsverteilung der Eingangsdaten berechnet wird.

**20.** Codierverfahren nach einem der Ansprüche 1 bis 19,
dadurch **gekennzeichnet,** daß zur Rekonstruktion mittels der Quantisierungskennlinie und der Wahrscheinlichkeitsverteilung der Eingangsdaten im Decoder für jeden einzelnen quantisierten Wert der Rekonstruktionswert so berechnet wird, daß der Quantisierungsfehler minimal wird.

**21.** Decodierverfahren zur Decodierung der nach dem digitalen Codierverfahren gemäß Anspruch 1 codierten Signale, bei dem bei der Wiedergabe eine entsprechende Decodierung und Rücktransformation erfolgt, dadurch **gekennzeichnet,** daß ein Raster bei der Decodierung ausgenutzt wird, in dem ein Teil der Codewörter variabler Länge angeordnet ist, wobei die restlichen Codewörter in die verbleibenden Lücken verteilt sind, so daß ohne vollständige Decodierung oder bei fehlerhafter Übertragung der Anfang eines Codeworts leichter aufgefunden wird.

**22.** Decodierverfahren nach Anspruch 21,
dadurch **gekennzeichnet,** daß eine Tabelle verwendet wird, in der Wertepaare gespeichert sind, von denen der erste Wert des Paares jeweils die Adresse enthält, die im Falle einer "0" im zu dekodierenden Wert anzuspringen ist, und der zweite Wert des Paares die Adresse im Falle einer "1", und daß Tabellenwerte ohne Adreßangabe das Codewort bezeichnen.

**23.** Decodierverfahren nach einem der Ansprüche 21 bis 22, dadurch **gekennzeichnet,** daß zur Berechnung der rekonstruierten Werte eine Tabelle verwendet wird, die durch Ermittlung tatsächlicher Erwartungswerte der Eingangswerte eines Quantisierungsintervall erstellt wird.

**Claims**

**1.** Digital coding method for the transmission of and/or for storing audio signals, and music signals in particular, wherein sampling values of the audio signal are converted into a string of second sampling values by means of a transformation function or a filter bank, which reflect the spectral composition of the audio signal, and wherein, using an encoder, this string of second sampling values is quantised and partly or completely coded into code words of different precision levels in correspondence with the requirements, wherein the probability of occurrence of the quantised spectral coefficients is correlated with the length of the code in such a way that the length of the code word is reduced as the frequency of occurrence of the spectral coefficient is increasing, and wherein, by the time of reproduction, an appropriate decoding and re-transformation are performed,
**characterised** in that one part of said code words of variable lengths is arranged in a raster, and that the remaining code words are distributed in remaining gaps of the raster such that the beginning of a code word is easier to find without complete decoding or in the case of faulty transmission.

2. Coding method according to Claim 1,
**characterised** in that for improvement of the reliability in transmission of continuously succeeding messages of different importance an equidistant raster is specified which has a raster length corresponding to the mean length of the messages to be transmitted, and that the most important message parts are arranged in this raster, and that the position of the less important messages is transmitted in this raster in addition to the most important message parts whenever this is necessary.

3. Coding method according to Claim 1 or 2,
**characterised** in that a beginning-of-block marker and additionally the entropy code length are transmitted for determining the beginning of the next message block in the event of a fault in transmission.

4. Coding method according to any of the Claims 1 to 3,
**characterised** in that for the calculation of a "permissible noise" for a data block signal sections are used which are longer than those coded in a block, or that the rule of calculation is dependent on the results of preceding time intervals.

5. Coding method according to Claim 4,
**characterised** in that for the calculation of the "permissible noise" for a data block an analysis of the signal energy is performed in the various frequency groups, and that the respective values of the preceding block, which are corrected by a "forget" factor, as well as the values of the actual block are jointly referred to for the calculation of the "permissible noise".

6. Coding method according to Claim 4 or 5,
**characterised** in that for the calculation of the "permissible noise" for a data block the energy values of the last data block are used in a way that low-amplitude values following values of a higher amplitude must be quantised with a lower level of precision.

7. Coding method according to any of the Claims 4 to 6,
**characterised** in that when a steep energy increase towards high frequencies the calculated permissible noise is reduced for the frequency group below the increase.

8. Coding method according to any of the Claims 1 to 7,
**characterised** in that even though on average a constant data rate is maintained the bit number made available in a block or claimed by the block may vary from the mean data rate as a function of the signal characteristics, the capacity of the transmission channel or for simplification of the coding operation.

9. Coding method according to Claim 8,
**characterised** in that the "filling level" of a buffer read out with an output bit cycle serves as control variable for the bit number to be assigned for synchronisation of the coding method with an optional input/output bit cycle ratio.

10. Coding method according to Claim 8 or 9,
**characterised** in that the number of the bits available for the coding of a data block is so varied as a function of the signal characteristics that, on the one hand, a constant data rate will be observed on average and the added-up variation from this mean value is not higher than a specific, previously determined value and not lower than another previously determined value, and that, on the other hand, an actual data rate "bit number available" is assigned to signal blocks of a wider spacing between the signal power in the individual frequency groups at the respective "permissible noise", which is higher than the data rate assigned to signal blocks of a narrower spacing.

11. Coding method according to any of the Claims 8 to 10,
**characterised** in that the number of those bits is subtracted from the bits available for one block, which are required by the additional data and which are transmitted on the same channel.

12. Coding method according to any of the Claims 8 to 11,
**characterised** in that when a particular bit combination is used for a synchronising word for block synchronisation the synchronising word and all bit combinations identical with the synchronising word by chance are distinguished from each other by an intentionally inserted additional bit.

**13.** Coding method according to any of the Claims 8 to 12,
**characterised** in that the outer iteration loop is interrupted if the inner loop cannot be safely terminated within the maximum number of iterations.

**14.** Coding method according to any of the Claims 1 to 13,
**characterised** in that regions where the "permissible noise" exceeds the signal energy are cancelled.

**15.** Coding method according to any of the Claims 1 to 13,
**characterised** in that the resulting succession of cancelled values is coded by a bit in the side information.

**16.** Coding method according to any of the Claims 1 to 15,
**characterised** in that the resulting succession of cancelled values is coded by a value in the table of possible quantising step levels for each frequency group in the side information.

**17.** Coding method according to any of the Claims 1 to 16,
**characterised** in that the quantising and reconstructing operations are mutually adapted in such a manner that the quantising error will be reduced to a minimum on average.

**18.** Coding method according to any of the Claims 1 to 17,
**characterised** in that the calculation of the reconstructed values in the receiver is performed by means of a table which is established by determining the actual values expected for the input values of a quantising interval.

**19.** Coding method according to any of the Claims 1 to 19,
**characterised** in that quantising is performed by means of a table which is calculated on the basis of the reconstruction characteristic and the probability distribution of the input data.

**20.** Coding method according to any of the Claims 1 to 19,
**characterised** in that for a reconstruction by means of the quantising characteristic and the probability distribution of the input data the reconstruction value is calculated in the decoder for each quantised value in such a way that the quantising error is reduced to a minimum.

**21.** Decoding method for decoding the signals coded in correspondence with the digital coding method according to Claim 1, wherein by the time of reproduction decoding and retransformation is performed,
**characterised** in that a raster is utilised in decoding in which one part of the code length of variable length is arranged, and the remaining code words are distributed in the remaining gaps such that the beginning of a code word will be found more easily without complete decoding or in the event of faulty transmission.

**22.** Decoding method according to Claim 21,
**characterised** in that a table is used which stores pairs of values of which the first value of the pair contains the respective address to which a branch is performed in the case of "0" in the value to be decoded, and the second value of the pair indicates the address in the case of "1", and that table values without address indication identify the code word.

**23.** Decoding method according to any of the Claims 21 to 22,
**characterised** in that a table is used for calculating the reconstructed values, which is established by determining actual values expected for the input values of a quantising interval.

## Revendications

**1.** Procédé de codage numérique pour la transmission et/ou la mémorisation des signaux audio, et des signaux de musique en particulier, dans lequel des valeurs de balayage du signal audio sont converties en une succession de deuxièmes valeurs de balayage, qui représentent la composition spectrale du signal audio, et dans lequel par l'emploi d'un codeur, cette succession de deuxièmes valeurs de balayage est quantifiée et codée, en partie ou complètement, en mots code aux niveaux de précision différents en correspondance avec les besoins, et dans lequel la probabilité de l'apparition des coefficients spectraux quantifiés est mise en corrélation avec la longueur du code d'une façon que plus la longueur du mot code soit réduite, plus la fréquence de l'apparition du coefficient spectral s'augmente, et dans lequel, au temps de reproduction, on réalise des opérations appropriées de décodage et de transformation inverse

**caractérisé** en ce qu'une partie desdits mots code à longueur variable est arrangée dans une trame, et en ce que les mots code de reste sont distribués dans un reste de vacances de la trame, de façon que le début d'un mot code soit trouvé plus facilement, sans décodage complet ou au cas de transmission troublée.

2. Procédé de codage selon la revendication 1,
**caractérisé** en ce que pour une amélioration de la fiabilité en transmission de messages à importance différente en succession continue, une trame équidistante est définie, dont la longueur de trame correspond à la longueur moyenne des messages à transmettre, et en ce que les parties de message les plus importantes sont arrangées dans cette trame, et en ce que la position des messages de moindre importance est transmise dans cette trame en plus aux parties de message les plus importantes, quand cela est nécessaire.

3. Procédé de codage selon la revendication 1 ou 2,
**caractérisé** en ce qu'une marque de début de mot et de plus la longueur du code d'entropie sont transmis afin d'établir le début du bloc de message suivant au cas d'une erreur de transmission.

4. Procédé de codage selon une quelconque des revendications 1 à 3,
**caractérisé** en ce que pour le calcul d'un "bruit toléré" pour un signal de bloc de données on utilise des segments qui sont plus longs que ceux qui sont codés dans un bloc, ou en ce que la formule de calcul fait fonction des résultats des intervalles de temps précédents.

5. Procédé de codage selon la revendication 4,
**caractérisé** en ce que pour le calcul du "bruit toléré" pour un bloc de données on réalise une analyse de l'énergie du signal dans les groupes de fréquences différents, et en ce que les valeurs respectives du bloc précédent, qui sont corrigées par un facteur "oubli", ainsi que les valeurs du bloc actuel sont prises en considération en commun pour le calcul du "bruit toléré".

6. Procédé de codage selon la revendication 4 ou 5,
**caractérisé** en ce que pour le calcul du "bruit toléré" pour un bloc de données on utilise les valeurs d'énergie du dernier bloc de données d'une façon que les valeurs à petite amplitude, qui suivent des valeurs d'une plus grande amplitude, doivent être quantifiées à un niveau de précision inférieur.

7. Procédé de codage selon une quelconque des revendications 4 à 6,
**caractérisé** en ce qu'à une augmentation raide de l'énergie vers des hautes fréquences, le bruit toléré calculé est réduit pour le groupe de fréquences en dessous de l'augmentation.

8. Procédé de codage selon une quelconque des revendications 1 à 7,
**caractérisé** en ce que même quand un débit de données constant en moyenne est retenu, le nombre de bits, qui est rendu disponible dans un bloc ou requis par le bloc, peut varier du débit de données moyen en fonction des caractéristiques des signaux, de la capacité de la voie de transmission ou afin de simplifier l'opération de codage.

9. Procédé de codage selon la revendication 8,
**caractérisé** en ce que le "niveau de remplissage" d'une mémoire tampon, qui est lue à un cycle de bits de sortie, sert en tant qu'une variable commandée variable pour le nombre de bits à affecter pour la synchronisation du procédé de codage à un rapport des cycles entrée/sortie quelconque.

10. Procédé de codage selon la revendication 8 ou 9,
**caractérisé** en ce que le nombre de bits disponible pour le codage d'un bloc de données est varié, en fonction des caractéristiques du signal, d'une façon que, d'un côté, un débit de données constant sera observé en moyenne et la variation cumulée de cette valeur moyenne ne sera plus grande qu'une valeur particulière, définie au préalable, et plus petite qu'une autre valeur déterminée au préalable, et
d'autre côté, un débit de données actuel "nombre de bits disponibles" est affecté aux blocs de signaux à un écart plus large entre l'énergie du signal dans les groupes de fréquences individuels au "bruit toléré" respectif, qui est plus grand que le débit de données affecté aux blocs de signaux à un écart plus étroit.

11. Procédé de codage selon une quelconque des revendications 8 à 10,

**caractérisé** en ce que le nombre de ceux bits est soustrait des bits disponibles pour un bloc, qui sont requis par les données additionnelles et qui sont transmises sur la même voie.

12. Procédé de codage selon une quelconque des revendications 8 à 11,
   **caractérisé** en ce que quand une combinaison de bits particulière est utilisée pour un mot de synchronisation pour la synchronisation du bloc, le mot de synchronisation et toutes les combinaisons de bits identiques, par hasard, avec le mot de synchronisation sont distingués l'un de l'autre par un bit additionnel inséré de propos délibéré.

13. Procédé de codage selon une quelconque des revendications 8 à 12,
   **caractérisé** en ce que la boucle d'itération extérieure est interrompue s'il n'est pas possible de terminer avant l'expiration du nombre maximal d'itérations.

14. Procédé de codage selon une quelconque des revendications 1 à 13,
   **caractérisé** en ce que des fourchettes, où du "bruit toléré" dépasse l'énergie du signal, sont effacées.

15. Procédé de codage selon une quelconque des revendications 1 à 13,
   **caractérisé** en ce que la succession résultante des valeurs effacées est codée par un bit dans l'information secondaire.

16. Procédé de codage selon une quelconque des revendications 1 à 15,
   **caractérisé** en ce que la succession résultante des valeurs effacées est codée par une valeur dans la table de niveaux possibles des pas de quantification pour chaque groupe de fréquences dans l'information secondaire.

17. Procédé de codage selon une quelconque des revendications 1 à 16,
   **caractérisé** en ce que les opérations de quantification et de reconstruction sont adaptées l'une à l'autre d'une manière que l'erreur de quantification soit réduite à un minimum en moyenne.

18. Procédé de codage selon une quelconque des revendications 1 à 17,
   **caractérisé** en ce que le calcul des valeurs reconstruites dans le récepteur est réalisé moyennant une table qui est établie en établissant des valeurs actuelles, qui sont attendues pour les valeurs d'entrée d'un intervalle de quantification.

19. Procédé de codage selon une quelconque des revendications 1 à 19,
   **caractérisé** en ce qu'une opération de quantification est réalisée moyennant une table qui est calculée à la base de la caractéristique de reconstruction et la distribution de probabilités des données d'entrée.

20. Procédé de codage selon une quelconque des revendications 1 à 19,
   **caractérisé** en ce que pour la reconstruction moyennant la caractéristique de quantification et la distribution de probabilités des données d'entrée, la valeur de reconstruction est calculée dans le décodeur pour chaque valeur quantifiée d'une façon que l'erreur de quantification soit réduite à un minimum.

21. Procédé de décodage à décoder les signaux codés en correspondance avec le procédé de codage selon la revendication 1, dans lequel, au temps de reproduction, une opération de décodage et de transformation inverse est réalisée,
   **caractérisé** en ce qu'une trame est utilisée en décodage, dans laquelle une partie de la longueur du code à longueur variable est arrangée, et les mots code de reste sont distribués dans le reste de vacances, de façon que le début d'un mot code soit trouvé plus facilement, sans décodage complet ou au cas de transmission troublée.

22. Procédé de décodage selon la revendication 21,
   **caractérisé** en ce qu'une table est utilisée, qui met en mémoire des paires de valeurs dont la première valeur dans la paire contient l'adresse respective à laquelle on branche au cas de "0" dans la valeur à décoder, et la deuxième valeur de la paire indique l'adresse au cas de "1", et que des valeurs tabellaires sans indication d'une adresse identifient le mot code.

23. Procédé de décodage selon une quelconque des revendications 21 à 22,
   **caractérisé** en ce qu'une table est utilisée pour le calcul des valeurs reconstruites, qui est établie en établissant des valeurs actuelles attendues pour les valeurs d'entrée d'un intervalle de quantification.

Gesamtlänge des zu einer Nachricht gehörenden Entropiecodes N

Synchronstellen

1. Wort

1. Rest

größtmögliche Einzelwortlänge = Synchronisationsrahmen

1. bis N/Z, Wort der Nachricht, beginnend jeweils nach der Länge des längstmöglichen Wortes

Pro Synchronisationsrahmen verbleibender Rest der nach Vergabe der Plätze mit definiertem Beginn mit den noch übrigen Bit aufgefüllt wird

"Überstehende" Bit, die im 1. Rest angeordnet werden

# Fig. 1

1. Nachricht   2. Nachricht   3. Nachricht   4. Nachricht   5. Nachricht   6. Nachricht

1. Nachricht   2. Nachricht   3. Nachricht   4. Nachricht   5. Nachricht

Besonders zu schützender
Nachrichtenteil

# Fig. 2

Auslesepointer

M-            M+

Eingabepointer falls
Bitsparkasse leer

Abgabepointer falls Bitsparkasse
voll

Reserve
für Regelung

M-, M+ : Marken für die Differenz
von Eingabe- und Auslesepointer bei
deren Überschreiten die Regelung für
die zu vergebende Bitzahl einsetzt

Kingpuffer

# Fig. 3

f

|Aspek|   Betrag der Spektralwerte
f         Häufigkeit

|Aspek|

Quantisierungsintervall für "1"

# Fig. 4